# EUROPEAN PATENT SPECIFICATION

(11) **EP 4 202 546 B1**
(45) Date of publication and mention of the grant of the patent: **28.08.2024**
(21) Application number: 21216726.6
(22) Date of filing: 22.12.2021
(51) Int. Cl.: G03F 1/62, G03F 7/20

(54) **AN EUV PELLICLE**
EUV-PELLIKEL
PELLICULE EUV

(43) Date of publication of application: 28.06.2023
(73) Proprietor: Imec VZW, 3001 Leuven (BE)
(72) Inventor: Timmermans, Marina, Bertem (BE); Pollentier, Ivan, Langdorp (BE); Gallagher, Emily, Burlington (US)
(74) Representative: AWA Sweden AB

(56) References cited:
- EP-A1- 3 483 655
- WO-A1-2020/243112
- TIMMERMANS MARINA Y ET AL: "CNT EUV pellicle tunability and performance in a scanner-like environment", ALGORITHMS AND TECHNOLOGIES FOR MULTISPECTRAL, HYPERSPECTRAL, AND ULTRASPECTRAL IMAGERY XIX - PROCEEDINGS OF SPIE, SPIE, US, vol. 11609, 23 March 2021 (2021-03-23), pages 116090Y - 116090Y, XP060140074, ISSN: 0277-786X, ISBN: 978-1-5106-4548-6, DOI: 10.1117/12.2584519

## Description

### Technical field

The present disclosure relates to an extreme ultraviolet (EUV) pellicle.

### Background

To enable high volume integrated circuit manufacturing with extreme ultraviolet lithography (EUVL), a pellicle is needed to protect the reticle from any fall-on particles. An EUV pellicle comprising a carbon nanotube (CNT) membrane is a promising pellicle solution, being transparent enough to limit the imaging and throughput impact while robust enough to survive handling and capable of stopping particles.

However, typical pellicle designs intended for use in EUVL, may cause non-negligible scattering of light transmitted through the pellicle. If light scattered by the pellicle is collected by the imaging system of the EUVL scanner, this may decrease the fidelity of the image transferred to a target wafer

A further challenge in EUV pellicle development is the thermal stability of the pellicle membrane which may need to withstand EUV source powers above e.g. 200 W. In the vacuum environment of an EUVL scanner, radiation heat is the primary mechanism for heat to be transferred from the pellicle membrane to the surroundings. Therefore, emissivity, the efficiency of a surface to emit energy as thermal radiation, is one of the key metrics for a pellicle membrane for high power EUVL applications. The relationship between emissivity and optical transmission of the pellicle membrane describes its thermo-optical properties.

Moreover, the mechanical strength of the pellicle membrane as well as its chemical durability in the etching environment of the EUVL scanner are vital for the pellicle lifetime.

EUV pellicles comprising a film of bundles of CNTs are known from WO 2020/243112 A1, EP 3 483 655 A1 and from TIMMERMANS MARINA Y ET AL: "CNT EUV pellicle tunability and performance in a scanner-like environment," Proc. SPIE 11609, Extreme Ultraviolet (EUV) Lithography XII, 116090Y (23 March 2021).

### Summary

In light of the above, it is an objective to provide an EUV pellicle comprising a CNT pellicle membrane enabling concurrent high EUV transmission, low scattering and sufficient thermal emissivity, e.g. such that the EUV pellicle may be suitable for current and anticipated future EUVL applications. Further and alternative objectives may be understood from the following.

According to an aspect there is provided an EUV pellicle comprising:
a pellicle frame; and
a pellicle membrane mounted on the pellicle frame and comprising a film of bundles of CNTs, wherein within any 2 µm × 2 µm region of the film:
   an average number of CNTs per bundle is at least 5,
   an average bundle diameter is in a range from 6 to 16 nm,
   an average areal density is in a range from 0.4 to 6 µg/cm²,
   an inter-bundle spacing is 250 nm or less, and
   a number of walls per CNT is 6 or less.

A pellicle membrane with these characteristics in combination enables an EUV pellicle with structural, optical and thermal properties meeting current and anticipated future EUVL scanner requirements. In particular, these characteristics of the pellicle membrane strike a balance between structural performance, thermal performance and optical performance.

An average number of CNTs per bundle of at least 5 may contribute to an improved mechanical stability of the pellicle membrane, as well as an improved expected lifetime by enabling the pellicle membrane to withstand an increased number of cycles or amount of time in the hydrogen environment typical for EUVL scanners.

An increased bundle diameter may provide an increased (thermal) emissivity, wherein a diameter of at least 6 nm enables an acceptable pellicle temperature for the temperatures and source powers expected in EUVL scanners. Meanwhile, limiting an average bundle diameter to 16 nm or less allows scattering (e.g. flare) to be controlled for the wavelength ranges and numeral apertures (NA) of interest in EUVL scanners. Flare is expected to increase with bundle diameter.

A wall count (i.e. number of walls per CNT) of 6 or less has been found to provide a good trade-off between on the one hand mechanical stability and flare control (favored by lower wall count), and on the other hand expected lifetime in the EUVL scanner environment (favored by greater wall count).

Together with the afore-mentioned characteristics, an average areal density in a range from 0.4 to 6 µg/cm² and an inter-bundle spacing of 250 nm or less enables a sufficient EUV transmittance and particle stopping ability. "Inter-bundle spacing" here refers a spacing between CNT bundles (in other words "gap size" or "pore size") within the plane of extension of the pellicle membrane. The pellicle membrane may e.g. have a transmission of at least 90% to EUV light, e.g. in a wavelength range from 5 nm to 40 nm, in particular in a wavelength range of 13.5 nm +/- 0.5.

The film may be formed by a network of overlapping / crossing bundles of CNTs. At least some of the CNT bundles of the film may be mutually bonded (i.e. at overlaps / crossings). A "CNT bundle" as used herein refers to a number of aligned and intertwined CNTs (which may be single-, double- or multi-walled). The CNTs of a bundle may further be bonded to each other by Van der Waals-type bonding. The bonding between CNTs of crossing bundles may be of a Van der Waals-type or of a cross-linking type (e.g. covalently cross-linked).

The film may form a free-standing CNT film. The term "free-standing film" as used herein refers a film being free-standing or self-supporting in the sense that it is capable of supporting its own weight when being suspended by e.g. a pellicle frame. In other words, a free-standing CNT film is capable of supporting its own weight when having a size being relevant for use in lithography, without any appreciable sagging. This free-standing property may contribute to the mechanical reliability of the pellicle membrane, which as will be further described below may also comprise a coating. Hence, a pellicle membrane comprising a free-standing CNT film may form a free-standing pellicle membrane.

According to embodiments, the film may comprise bundles of: single-walled CNTs, double-walled CNTs or multi-walled CNTs; and/or bundles of combinations of two or more of: single-walled CNTs, double-walled CNTs, or multi-walled CNTs.

The term "single-walled CNT" (SWCNT) refers to a CNT having exactly (i.e. only) one wall. The term "double-walled CNT" (DWCNT) refers to a CNT having exactly (i.e. only) two walls. A DWCNT may consist of two concentric SWCNTs of different radii. The term "multi-walled CNT" (MWCNT) refers to a CNT having three or more walls. A MWCNT may consist of three or more concentric SWCNTs of different radii.

According to embodiments, the film may comprise multi-walled CNTs and single-walled and/or double-walled CNTs, and wherein a percentage by mass of multi-walled CNTs of the film is smaller than a concentration by mass of single- or double-walled CNTs of the film.

The presence of SWCNTs and/or DWCNTs may contribute to favorable structural and optical properties (e.g. high EUV transmission and low scattering). The MWCNTs may contribute to an increased heat dissipation. Since thermal emissivity is dependent on the size and shape of the object, the heat dissipation of the MWCNTs may be expected to exceed the heat dissipation of the SWCNTs or DWCNTs. The greater wall count of MWCNTs may further contribute to an increased lifetime of the pellicle membrane. Providing the MWCNTs in minority (by weight%) may further ensure that the target areal density range and CNT per bundle range is not exceeded.

Different approaches for combining single- or double-walled CNTs and multi-walled CNTs are envisaged:
According to embodiments, the film may comprise a first layer of bundles of SWCNTs and/or DWCNTs, and a second layer of MWCNTs, wherein the first layer forms a network of overlapping CNTs (e.g. a free-standing film) and the other layer forms a layer of aligned CNTs arranged on the first layer, or vice versa.

SWCNTs and/or DWCNTs may hence be combined with MWCNTs in a convenient and easily controllable manner, e.g. by transferring the layer of MWCNTs onto the main surface of the SWCNT- or DWCNT-film or vice versa. The layer of MWCNTs may thus have a structure chosen to optimize in terms of thermo-optical properties, with little or no regard to the structural properties of the MWCNTs layer.

According to embodiments, the membrane may comprise a (combined) film of SWCNT- and/or DWCNT-bundles, and MWCNT bundles, e.g. forming a common network of overlapping SWCNT- and/or DWCNT- bundles and MWCNT bundles. The film may be formed in a convenient and easily controllable manner, e.g. by mixing different CNTs in a solution prior to pellicle membrane fabrication, or synthesizing different types of CNTs within one or multiple growth reactors, or combining respective layers of networks of overlapping different types of CNTs.

By "inter-mixing" MWCNTs with the SWCNTs or DWCNTs in this fashion, the thermal properties of the MWCNTs may be evenly distributed throughout the film.

According to embodiments, the pellicle membrane may be an un-coated pellicle membrane. An "un-coated" pellicle membrane (i.e. implying that the surfaces of the CNT bundles are exposed to the ambient) may ensure that the high EUV transmittance and heat tolerance inherent to CNT bundles may be taken advantage of to the greatest extent in the pellicle membrane. Meanwhile, the above-discussed characteristics of the pellicle membrane may still enable an acceptable lifetime, despite the surfaces of the CNT bundles being directly exposed to the EUVL scanner ambient.

According to embodiments of an un-coated pellicle membrane, an average areal density may be in a range from 1 to 6 µg/cm²

An average areal density in this range makes the pellicle membrane suitable for use in EUVL scanner operating with 0.33 NA at 200-600 W source power.

According to embodiments of an un-coated pellicle membrane, an average areal density may be in a range from 0.5 to 3 µg/cm².

An average areal density in this range makes the pellicle membrane suitable for use in EUVL scanner operating with 0.55 NA at 600-1000 W source power.

According to embodiments, the pellicle membrane may be a coated pellicle membrane, wherein an average bundle diameter may be in a range from 6 to 14 nm, and a number of walls per CNT may be 4 or less.

A coating may make the CNT membrane less sensitive to exposure to the hydrogen plasma in the scanner atmosphere. This may enable an acceptable lifetime also for pellicle membranes with lower average bundle count and diameter, and lower CNT wall count, such that flare still may be controlled.

According to embodiments of a coated pellicle membrane, a coating of the pellicle membrane may comprise a coating material selected from the group of Al, B, C, Hf, La, Mo, Nb, Ru, Si, Ti, Y, or Zr; or carbides, nitrides, oxides or fluorides thereof, as well as their combinations (e.g. yttrium aluminum oxide, ZrAlOₓ, yttria-stabilized zirconia, YSZ, yttrium oxyfluoride, YOF).

According to embodiments, the coating may further comprise a seed material selected from the group of: C, Zr, ZrₓO_{y}, ZrN, Hf, HfₓO_{y}, HfN, B, B₄C, BN, Y, YₓO_{y}, YN, YF_{z}, YOF, La, LaN, SiC, SiN, Ti, TiN, W, Be, Au, Ru, Al, AlₓO_{y}, Mo, MoN, Sr, Nb, Sc, Ca, Ni, Ni-P, Ni-B, Cu, Ag,
and wherein the seed material forms a seed layer on the film of CNT bundles and the coating material forms an outer coating layer on the seed layer.

These materials may provide a seeding function for a broad class of materials which may be deposited by ALD and which may form an outer coating with sufficient reliability and EUV transmission.

Advantageously, the seed material and the coating material may be selected from the group of: Y seed material and YₓO_{y}, YF_{z}, YOF coating materials, Zr or Zr oxide seed material and ZrₓO_{y} coating materials; B or B oxide seed material and ZrₓO_{y} coating material, HfₓO_{y} coating material or AlₓO_{y} coating material; B₄C seed material and ZrₓO_{y} coating material, HfₓO_{y} coating material or AlₓO_{y} coating material; Zr or ZrₓO_{y} seed material and AlₓO_{y} coating material; Zr seed material and ZrAlOₓ coating material; AlₓO_{y} seed material and YₓO_{y}, YF_{z}, ZrₓO_{y} or HfₓO_{y} coating materials; Mo seed material and ZrₓO_{y} coating material.

According to embodiments of a coated pellicle membrane an average areal density of the film of CNT bundles may be in a range from 0.4 to 4.0 µg/cm²

An average areal density in this range makes the pellicle membrane suitable for use in EUVL scanner operating with 0.33 NA at 200-600 W source power.

An average thickness of the coating may be 2.0 nm or less and a degree of coverage of the coating on the film may be at least 80 %. A degree of coverage of X% should herein be understood as the coating covering at least X% of a surface area of the bundles of CNTs (e.g. within any 2 µm × 2 µm region of the pellicle membrane). Hence, a coverage of 80% provides a "mostly" continuous coating of the film, thereby enabling a reliable protection of the CNTs. For a coating thickness greater than 1.0 nm and a coverage of at least 80%, the composition of the coating may advantageously be selected to provide optical constants such that excessive EUV transmission loss and scatter due to the coating is prevented. For example, the coating may be formed such that the refractive index of the coating is at least 0.94, and the extinction coefficient is 0.015 or lower (e.g. at EUV wavelengths).

An average thickness of the coating may alternatively be 1.0 nm or less and a degree of coverage of the coating on the film may be at most 50 %. Hence, a partially coated film may be provided, wherein the composition of the coating may be selected with less regard to the optical constants. It is contemplated that also a partial coating may provide sufficient protection against hydrogen etching since the defect locations in the CNTs (being the most sensitive locations of the film with respect to hydrogen etching) tend to be coated first.

According to embodiments of a coated pellicle membrane an average areal density of the film of CNT bundles may be in a range from 0.4 to 2.0 µg/cm².

An average areal density in this range makes the pellicle membrane suitable for use in EUVL scanner operating with 0.55 NA at 600-1000 W source power.

An average thickness of the coating may be 1.0 nm or less and a degree of coverage of the coating on the film may be at least 80 %. Hence, a "mostly" continuous coating of the film may be provided, thereby enabling a reliable protection of the CNTs. For a coating thickness greater than 0.5 nm and a coverage of at least 80%, the composition of the coating may advantageously be selected to provide optical constants such that excessive EUV transmission loss and scatter due to the coating is prevented. For example, the coating may be formed such that the refractive index of the coating is at least 0.94, and the extinction coefficient is 0.015 or lower (e.g. at EUV wavelengths).

An average thickness of the coating may alternatively be 0.5 nm or less and a degree of coverage of the coating on the film may be at most 50 %. Hence, a partially coated film may be provided, wherein the composition of the coating may be selected with less regard to the optical constants.

According to a further aspect a lithographic reticle system may be provided, comprising a reticle, and a EUV pellicle as set out in the above, the pellicle frame being mounted on the reticle.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.
Figure 1 is a schematic illustration of a EUV pellicle and a reticle system.
Figures 2a-c shows different types of CNTs and CNT films.
Figure 3a-c schematically illustrate non-bundled and bundled CNTs.
Figures 4 and 5 illustrate examples of coated CNT films.

### Detailed description

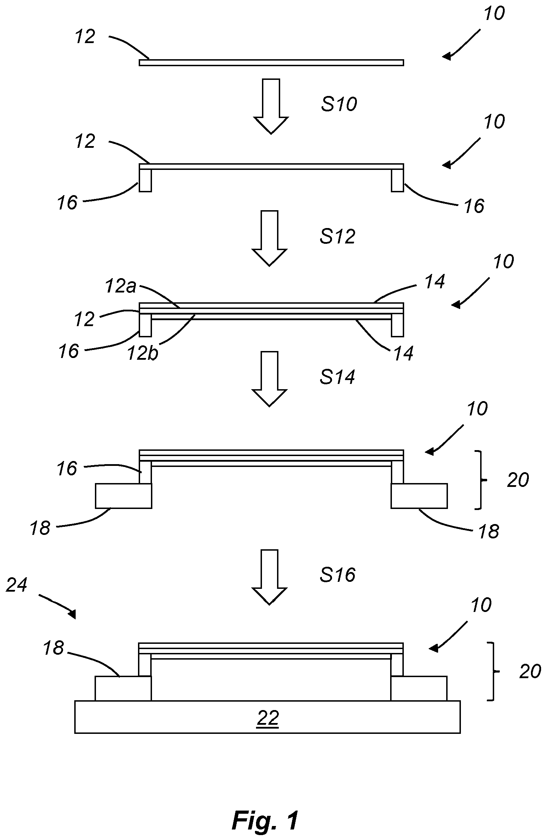

Fig. 1 schematically illustrates the building blocks and assembly of a EUV pellicle 20, and of a reticle system 24 comprising the pellicle 20 and a reticle 22, i.e. a "pelliclized reticle". The structures in Fig. 1 are shown in schematic cross-sectional side-views.

The pellicle 20 comprises a pellicle membrane 10, or shorter "membrane". The membrane 10 is a CNT membrane and accordingly comprises a film of bundles of CNTs 12. The term "CNT film", or even merely "film", may in the following be used as a shorthand for "a film of bundles of CNTs".

The membrane 10 is assembled with a border 16 (as indicated by step S10). The membrane 10 may be attached to the border 16 along its edges. The membrane 10 may be attached to the border e.g. by an adhesive, by cold-welding, or in any other conventional manner known in the art.

Step S12 indicates an optional step of coating the film 12 to form a coated membrane 10. As will be disclosed in greater detail below, the coating process may comprise a pre-coating step and a subsequent second coating step to form a coated membrane having a coating 14 with a degree of coverage and uniformity desirable for EUVL applications. However, a coating process omitting a pre-coating step is also possible. The coating 14 may as shown be formed on one or both sides 12a, 12b of the film 12. Assembling the membrane 10 and the border 16 prior to the optional coating process of step S12 may facilitate handling of the membrane 10 during the coating process. However, it is also possible to first coat the film 12 and thereafter assemble the coated film 12 with the border 16. If a step S12 of coating is performed, the membrane 10 may be formed by the film 12 and the coating 14 thereon. If no coating is performed, the membrane 10 may be formed by the film 12 (i.e. the membrane 10 may consist of the CNT film 12).

Pre-treatment (or functionalization) of the CNT membrane, for example oxidation via UV-ozone exposure or anneal in a specific atmosphere, could also be applied prior to the coating with or without a seed layer.

The membrane 10 (which may be coated) and the border 16 are assembled with a pellicle frame 18 (as indicated by step S14) to form the pellicle 20. The border 16 may be attached to the frame 18 for instance by an adhesive, by cold-welding or by some mechanical fixation structures such as clamps. The frame 18 may for instance be formed by Si, SiN, SiO₂ or quartz. However other materials are also possible, such as metal, plastic or ceramic materials. It is also an option to omit a border and instead directly assemble the membrane 12 with the pellicle frame 18, for instance by directly attaching the membrane 12 to the frame 18 using an adhesive.

Step S16 depicts assembly of the reticle system 24 comprising the pellicle 20 mounted over the reticle 22. The frame 18 may be attached to the reticle 22 using an adhesive. The reticle may be formed as a reflective reticle defining a pattern which is to be transferred to a wafer.

The membrane 10 may have a rectangular shape, although other shapes such as circular, oval or polygonal shapes also are conceivable. The border 16 and the frame 18 may have a shape corresponding to the shape of the membrane 10.

The membrane of an EUV pellicle (e.g. membrane 10 of pellicle 20) needs to meet various and sometimes competing criteria in order to be suitable for EUVL applications. A CNT-film has a considerable configurability in terms of structure, which in turn influences its suitability for use as an EUV pellicle membrane. In particular, an insight underlying the present inventive concept is that a pellicle membrane comprising a film of bundles of CNTs with:
- an average number of CNTs per bundle of at least 5,
- an average bundle diameter in a range from 6 to 16 nm,
- an average areal density in a range from 0.4 to 6 µg/cm²,
- an inter-bundle spacing of 250 nm or less, and
- a number of walls per CNT of 6 or less,
enables a pellicle membrane meeting current and anticipated future EUVL scanner requirements in terms of structural, thermal and optical performance. For conciseness, these parameters may in the following be commonly referred to as "the structural parameters" of the film or pellicle membrane.

As may be appreciated, any CNT film (even if fabricated to have some degree of structural regularity) will within any region (of microscopic or macroscopic size) exhibit some amount of spread or randomness in each of these structural parameters. This spread will tend to increase as the size of the region considered is increased. As an example, simulations and real measurements using a scanning electron microscope (SEM) on typical CNT films indicate that the frequency of a given size of inter-bundle spacing follows a logarithmic dependency with the inter-bundle spacing.

However, as realized by the inventors, for the purpose of the suitability of a CNT-film for use as an EUV pellicle membrane, it is sufficient that these parameters lie in the above ranges within any arbitrarily selected 2 µm × 2 µm region of the film (or equivalently pellicle membrane), i.e. a square region with sides of 2 µm length. A region of this size is further readily inspectable by a SEM, such that these structural parameters in practice may be quantified by measurements on a physical film.

The film 12 may be formed by a network or web of overlapping / crossing bundles of CNTs. The film 12 may comprise one or more layers of bundles of CNTs. The network may e.g. be random or regular. The film may advantageously be formed as a free-standing film. The film 12 may comprise bundles of a single type of CNTs, e.g. bundles of SWCNTs, bundles of DWCNTs, or bundles of MWCNTs. The film may additionally or alternatively comprise bundles of CNTs of mixed types, e.g. bundles of SWCNTs, DWCNTs or MWCNTs. As will be further disclosed herein, the film may comprise combinations of two or more different types of CNT bundles, either single-type or mixed-type CNT bundles. SWCNTs may have a diameter in the range of 0.5-2 nm. DWCNTs may have a diameter in the range of 1-4 nm. MWCNTs may have a diameter in the range of 3-30 nm. These ranges are however merely non-limiting examples and the different types of CNTs may have an even greater variation of diameter. It is to be noted that the wording "film of bundles of CNTs" does not preclude presence of also individual CNTs within the film, as the bundling of CNTs will typically not be complete within a film of a size typical for pellicle membranes.

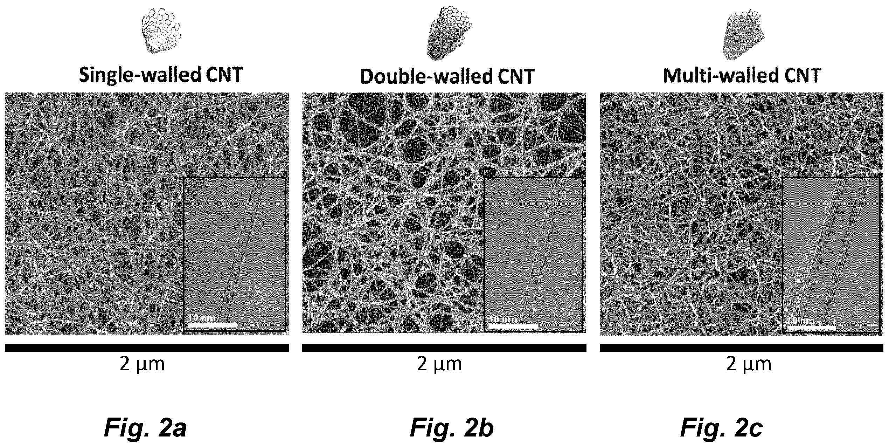

Figs. 2a-c show SEM images of un-coated films of SWCNTs (Fig. 2a), DWCNTs (Fig. 2b) and MWCNTs (Fig. 2c). Black areas indicate gaps in the film and white areas indicate a bundles of CNTs. Above the respective SEM images conceptual representations of an SWCNT, a DWCNT and an MWCNT are shown. The figures visualizes the spread of the respective structural properties of the films.

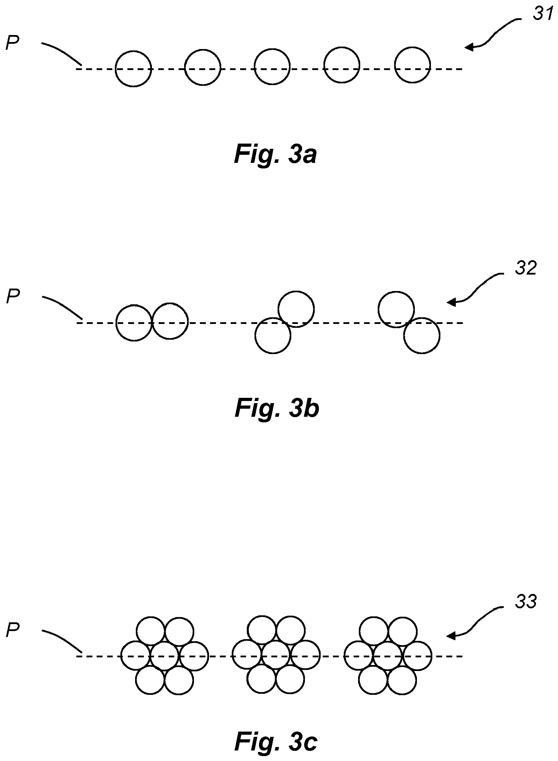

Figs. 3a-c schematically illustrate cross sectional views of CNT films 31, 32, 33 taken across the plane P of the respective films. Fig. 3a shows a film 31 comprising non-bundled CNTs. Fig. 3b shows a film comprising bundles of two CNTs. Fig. 3c shows a film 33 comprising bundles of seven CNTs. It is to be understood that the views are highly conceptualized and that the CNTs of a bundle may be intertwined and be twisted and bent around each other, along the length direction of the bundle. The CNTs may in each of the views be single-, double- or multi-walled.

CNT films with the above-stated structural parameters may be formed using state of the art fabrication techniques, which per se are known in the art. Examples include dry transfer techniques, solvent based techniques (i.e. harvesting from a solution), and drawing CNTs from forests.

In the dry transfer approach, CNTs may be synthesized using floating catalyst (aerosol) CVD. The CNTs may bundle in gas phase and then be collected on a filter in a random network and dry-transferred onto a border (e.g. the border 16). Either single-type CNT-bundles (e.g. SWCNT-only, DWCNT-only or MWCNT-only) or mixed-type CNT-bundles (e.g. SWCNT, DWCNT and/or MWCNT) may be formed by controlling e.g. the growth conditions, choice of catalyst and gasses, temperature, etc. as per se is known in the art.

A CNT film comprising a network of different single-CNT type bundles may be formed by synthesizing a first type of CNTs (e.g. SWCNTs or DWCNTs) in a first growth reactor and a second type of CNTs (e.g. MWCNTs) in a second growth reactor and, after individual bundling in gas phase, collecting the different CNT bundle types on a filter.

In the dry transfer approach, the structural parameters of the CNT film (density, CNT type, bundling, diameter etc.) may be influenced by, for example, the growth conditions, e.g. the choice of catalyst and gasses (including carbon source and assistant gasses); temperature; flow rate and type (turbulent, laminar etc.); pressure , reactor geometry and type etc.; the type of collection (or filtration) system used for forming the CNT film and collection time as well as other parameters per se known in the art.

In the solvent-based approach, CNTs (e.g. synthesized using arc-discharge, laser ablation or CVD) may be dispersed in a liquid solvent, such as water with an addition of a surfactant, and after bundling in liquid phase, be collected via vacuum filtration on e.g. a filtration membrane. The CNT film may subsequently be transferred to a border (e.g. the border 16). The types of CNTs forming the bundles (e.g. single- or mixed-type bundles) may be determined by the composition of CNTs in the dispersion.

In the solvent-based approach, the structural parameters of the CNT film (density, CNT type, bundling, diameter etc.) may be influenced by, for example, choice of the CNT powder for dilution; CNT dispersion approach (including the amount of surfactant, CNT concentration, solvents etc.); sonication approach; agitation; vacuum filtration rate/duration, filter pores, surfactant removal, CNT membrane separation from the filter etc. to name a few.

In the approach based on drawing of CNTs from a forest, a forest of vertically oriented CNTs may be grown by a fixed catalyst CVD method and subsequently be drawn to form a layer of CNTs. Due to the vertical alignment of the CNTs, also the drawn layer of the CNTs tend to present a high degree of alignment. It is possible to stack two or more drawn layers (of a same or different types of CNTs) on top of each other to form a two- or multi-layered CNT film.

In the forest-based approach, the structural parameters of the CNT film may be influenced by the growth conditions (e.g. catalyst type and density, temperature, pressure, gasses etc.); CNT drawing and placement approaches, to name a few examples.

It is also possible to combine a forest-based approach with either the dry- or solvent-based approach, e.g. by transferring a drawn layer of CNTs onto a layer of CNTs formed in accordance with the dry- or solvent-based approach, or vice versa. It is also possible to directly draw a layer of CNTs onto a layer of CNTs formed in accordance with the dry- or solvent-based approach.

Current typical EUVL scanners have a source power of 200-600 W and 0.33NA (numerical aperture). It is expected that future EUVL scanners may use even higher source powers, e.g. 600-1000 W and 0.55NA. The higher source power increases the importance of sufficient thermal emissivity for the pellicle membrane. A higher NA will collect more angular scattering in the projection optics, which makes it more important to control scattering in a pellicle for a 0.55NA system.

Table I sets out ranges for the structural parameters for an un-coated pellicle membrane, tailored to make it suitable for use in a 0.33NA EUVL scanner with a source power of 200-600 W.

Table II sets out ranges for the structural parameters for an un-coated pellicle membrane, tailored to make it suitable for use in a 0.55NA EUVL scanner with a source power of 600-1000 W. The lower areal density values in Table II may be understood considering that a higher NA may capture more scattered light into the projection optics of the EUVL scanner and a reduced areal density may reduce the amount of scattered light.

**Table I:**

| **CNT parameter (average)** | **Range** |
|---|---|
| number of CNTs per bundle | ≥ 5 |
| bundle diameter (nm) | 6 to 16 nm |
| areal density | 1 to 6 µg/cm² |
| Inter-bundle spacing (nm) | ≤ 250 nm |
| number of walls per CNT | ≤ 6 |

**Table II:**

| **CNT parameter (average)** | **Range** |
|---|---|
| number of CNTs per bundle | ≥ 5 |
| bundle diameter (nm) | 6 to 16 nm |
| areal density | 0.5 to 3 µg/cm² |
| Inter-bundle spacing (nm) | ≤ 250 nm |
| number of walls per CNT | ≤ 6 |

Table III sets out example values of the structural parameters for a CNT film of bundles of DWCNTs with a 2.5 nm individual CNT diameter, for use in a 0.33NA EUVL scanner with a source power of 300 W. "EUVT core" indicates the transmission of the CNT film at 13.5 nm, where "core" indicates that the CNT film is uncoated. "Gap" refers to the maximum inter-bundle spacing. Rows 1 and 2 show values optimized for the same maximum temperature (600 °C), but different levels of flare into the NA ("flareNA" of 0.3% vs 0.2%). Row 3 shows values optimized for a higher maximum temperature than row 2 (800 °C) and a same level of flare 0.2% flare.

As may be seen, a requirement for reduced flare leads to a lower optimum bundle diameter (9 nm vs 10.5 nm) and a lower optimum density (4 µg/cm²).

Meanwhile, a higher maximum temperature of the pellicle membrane leads to a lower optimum bundle diameter (8 nm vs 9 nm) and a lower areal density (4 µg/cm²), e.g. due to a lower emissivity requirement.

**Table III:**

| | **EUVT core (%) / areal density** (µg/cm²) | **Bundle diam. (nm)** | | **CNTs** / **bundle** | **Gap (nm)** |
|---|---|---|---|---|---|
| DWCNT | 91.6 / 4.7 | | 10.5 | 18 | 41 |
| T<600 °C, flareNA<0.3% | | | | | |
| DWCNT | 93.2 / 3.8 | | 9 | 13 | 38 |
| T<600 °C, flareNA<0.2% | | | | | |
| DWCNT | 91.0/5.1 | | 8 | 10 | 25 |
| T<800 °C, flareNA<0.2% | | | | | |

Table IV sets out example values of the structural parameters for CNT films of bundles of different single types of CNTs (e.g. solely SWCNTs, DWCNTs or MWCNTs), for use in a 0.33NA EUVL scanner with a source power of 300 W, optimized for a maximum level of flare of 0.3% and a maximum temperature of 600 °C. The value following the type of CNT in the first column indicates the average diameter of the individual CNTs of the bundles. The bracketed number "n" in "MW(n)CNT" indicates the average number of walls of the MWCNTs. As may be seen, for different CNT types, some of the parameters can be similar (e.g. EUVT core and bundle diameter), while other parameters (number of CNTs per bundle) can differ. It is to be noted that the final row with MW(6)CNT has been included as merely a comparative example, falling outside the ranges provided in Table II due to an insufficient number of CNTs per bundle.

**Table IV:**

| | **EUVT core (%) / areal density** (µg/cm²) | **Bundle diam. (nm)** | | **CNTs / bundle** | | **Gap (nm)** |
|---|---|---|---|---|---|---|
| SWCNT 2 nm | 92.2 / 4.4 | | 11 | | 30 | 37 |
| DWCNT 2.5 nm | 91.6 / 4.7 | | 10.5 | | 18 | 41 |
| MW(3)CNT 3nm | 91.6 / 4.7 | | 10.5 | | 12 | 45 |
| MW(4)CNT 5 nm | 92.4 / 4.3 | | 11 | | 5 | 49 |
| MW(6)CNT 6.5nm | 92.4 / 4.3 | | 11 | | 3 | 51 |

Table V sets out example values of the structural parameters for CNT films of bundles of different single types of CNTs (e.g. solely SWCNTs or MW(3)CNTs), as well as for different mixtures thereof, for use in an 0.33NA EUVL scanner with a source power of 300 W, optimized for a maximum level of flare of 0.3% and a maximum temperature of 600 °C. The individual CNT diameter of SWCNTs and MW(3)CNTs are 2 nm and 3 nm respectively.

**Table V:**

| | **EUVT core (%) / areal density** (µg/cm²) | **Bundle diam. (nm)** | | **CNTs** / **bundle** | **Gap (nm)** |
|---|---|---|---|---|---|
| SWCNT | 92.2 / 4.4 | | 11 | 30 | 37 |
| MW(3)CNT | 91.6 / 4.7 | | 10.5 | 12 | 52 |
| SWCNT (wt 50%) + MW(3)CNT (wt 50%) | 92.0 / 4.5 | | 10.5 | 21 | 45 |
| SWCNT (wt 20%) + MW(3)CNT (wt 80%) | 91.6 / 4.7 | | 10.5 | 16 | 50 |
| SW 2nm (wt 70%)+ MW(3)CNT (wt 30%) | 92.2 / 4.4 | | 11 | 26 | 46 |

Table VI sets out example values of the structural parameters for CNT films of bundles of different single types of CNTs (e.g. solely DWCNTs or MW(6)CNTs), as well as for different mixtures thereof, for use in an 0.33NA EUVL scanner with a source power of 300 W, optimized for a maximum level of flare of 0.3% and a maximum temperature of 600 °C. The individual CNT diameter of the DWCNTs and MW(6)CNTs are 2.5 nm and 6.5 nm respectively. As noted in connection with Table IV, a CNT film of solely MW(6)CNTs has an insufficient number of CNTs per bundle. This applies also to MW(6)CNTs in an 80-to-20 by wt% mixture with DWCNTs. However, as shown in the table, mixtures with a smaller content of MW(6)CNTs may still result in a film meeting the acceptable average range of CNTs per bundle.

**Table VI:**

| | **EUVT core (%) / areal density** (µg/cm²) | **Bundle diam. (nm)** | | **CNTs** / **bundle** | | **Gap (nm)** | |
|---|---|---|---|---|---|---|---|
| DWCNT | 91.6 / 4.7 | | 10.5 | | 18 | | 41 |
| MW(6)CNT | 92.4 / 4.3 | | 11 | | 3 | | 51 |
| DWCNT (wt 50%) + MW(6)CNT (wt 50%) | 92.0 / 4.5 | | 10.5 | | 10 | | 42 |
| DWCNT (wt 20%) + MW(6) (wt 80%) | 92.0 / 4.5 | | 10.5 | | 5 | | 46 |
| DWCNT (wt 70%) + MW(6)CNT (wt 30%) | 91.8 / 4.6 | | 10.5 | | 13 | | 41 |

Table VII sets out example values of the structural parameters for CNT films of bundles of DWCNTs (with an individual CNT diameter of 2.5 nm), for use in an 0.33NA EUVL scanner with different source powers in a range from 200 W to 600 W, and in an 0.55NA EUVL scanner with source powers of 600 W and 1000 W. All examples are optimized for a maximum level of flare of 0.2% and a maximum temperature of 600 °C.

**Table VII: Impact of source power and NA**

| | **EUVT core (%)** / **areal density** (µg/cm²) | **Bundle diam. (nm)** | | **CNTs** / **bundle** | **Gap (nm)** | |
|---|---|---|---|---|---|---|
| DWCNT | 92 / 4.5 | | 8 | 10 | | 38 |
| 200 W/0.33NA | | | | | | |
| DWCNT | 93.2 / 3.8 | | 9 | 13 | | 38 |
| 300 W/0.33NA | | | | | | |
| DWCNT | 94.2 / 3.2 | | 10 | 16 | | 49 |
| 400 W/0.33NA | | | | | | |
| DWCNT | 95.2 / 2.7 | | 11.5 | 21 | | 67 |
| 600 W/0.33NA | | | | | | |
| DWCNT | 96.4 / 2.0 | | 9.5 | 16 | | 70 |
| 600 W/0.55NA | | | | | | |
| DWCNT | 97.2 / 1.5 | | 11.5 | 21 | | 105 |
| 1000 W/0.55NA | | | | | | |

Rows 1-4 indicate that a larger bundle diameter and lower areal density is required for increasing scanner power, e.g. to provide a more optimal emissivity to control the temperature.

Rows 4-5 indicate that for a same power but a larger NA, a smaller bundle diameter and a lower areal density is required, e.g. to control the scattering into the higher NA.

Table VIII sets out ranges for the structural parameters for a coated pellicle membrane, tailored to make it suitable for use in an 0.33NA EUVL scanner with a source power of 200-600 W.

Table IX sets out ranges for the structural parameters for a coated pellicle membrane, tailored to make it suitable for use in an 0.55NA EUVL scanner with a source power of 600-1000 W.

**Table VIII:**

| **CNT parameter (average)** | **Range** |
|---|---|
| number of CNTs per bundle | ≥ 5 |
| bundle diameter (nm) | 6 to 14 nm |
| areal density | 0.4 to 4.0 µg/cm² |
| Inter-bundle spacing (nm) | ≤ 250 nm |
| number of walls per CNT | ≤ 4 |

**Table IX:**

| **CNT parameter (average)** | **Range** |
|---|---|
| number of CNTs per bundle | ≥ 5 |
| bundle diameter (nm) | 6 to 14 nm |
| areal density | 0.4 to 2.0 µg/cm² |
| Inter-bundle spacing (nm) | ≤ 250 nm |
| number of walls per CNT | ≤ 4 |

As may be understood from a comparison with Tables I and II, coating may protect the CNT film from exposure to the hydrogen plasma in the scanner atmosphere. An average bundle count and diameter may hence be reduced while still maintaining an acceptable lifetime.

Tables X and XI show optimized coating parameters for a pellicle membrane suitable for use in a 0.33NA EUVL scanner with a source power of 200-600 W, and in a 0.55NA EUVL scanner with a source power of 600-1000 W, respectively. The coating parameters are determined for a mostly continuous coating, e.g. an at least 80% coverage of the exposed outer surfaces of the CNT film. The stated thickness range of the coating refers to an average thickness within a same 2 µm × 2 µm region of the film as for the structural parameters of the CNT film, wherein the average is calculated over the entire (outer) surface area of the CNT bundles (coated or not). "Thickness" should in particular be understood as a thickness in a radial direction, measured from the surface of the respective CNT bundles. Accordingly, in practice an average thickness of coating may be estimated by calculating an average thickness based on thickness measurements at a plurality of (randomly) selected measurement locations within the 2 µm × 2 µm region.

**Table X:**

| **Coating parameter (average)** | **Range** |
|---|---|
| Thickness (nm) | ≤ 2.0 |
| Refractive index at 13.5 nm | ≥ 0.94 |
| Extinction coefficient at 13.5 nm | ≤ 0.015 |

**Table XI:**

| **Coating parameter (average)** | **Range** |
|---|---|
| Thickness (nm) | ≤ 1.0 |
| Refractive index at 13.5 nm | ≥ 0.94 |
| Extinction coefficient at 13.5 nm | ≤ 0.015 |

As may be seen from the tables, a higher source power motivates a less thick coating, to limit scattering and transmission loss. The refractive index (n) and the extinction coefficient (k) of the coating are material dependent properties, related strongly to transmission loss and scattering. The composition of the coating should hence be selected such that the above stated ranges of n and k are met.

The coating material may generally be selected as any material which may provide sufficient protection of the CNTs against the hydrogen atmosphere, and enable an outer coating with sufficient EUV transmission. The coating material may be selected from the group of: Al, B, C, Hf, La, Mo, Nb, Ru, Si, Ti, Y, or Zr; or carbides, nitrides or oxides thereof, as well as their combinations (e.g. yttrium aluminum oxide or yttria-stabilized zirconia). The coating material may be deposited by e.g. atomic layer deposition (ALD), such as thermal ALD a plasma-enhanced ALD.

The coating may be a composite-layer coating comprising an outer coating (e.g. of any of the coating materials listed above), and an inner pre-coating or seed layer formed prior to depositing the outer coating. The seed material may generally be selected as any material which may provide a seeding function for the subsequent deposition of the outer coating. The seed material may for example be selected from the following group of: C, Zr, ZrₓO_{y}, ZrN, Hf, HfₓO_{y}, HfN, B, B₄C, BN, Y, YₓO_{y}, YN, YF₃, YOF, La, LaN, SiC, SiN, Ti, TiN, W, Be, Au, Ru, Al, AlₓO_{y}, Mo, MoN, Sr, Nb, Sc, Ca, Ni, Ni-P, NiB, Cu, Ag. The seed material may be deposited e.g. by PVD techniques such as e-beam evaporation, thermal evaporation (i.e. non-e-beam techniques such as thermal evaporation by resistive heating evaporation or molecular beam epitaxy) or remote plasma sputtering. A seed layer quality may be improved by limiting a deposition rate, e.g. 0.7 angstroms/s or lower.

Examples of combinations of seed material and outer coating material include: Y seed material and YₓO_{y}, YF_{z}, YOF coating materials, Zr or Zr oxide seed material and ZrₓO_{y} coating materials; B or B oxide seed material and ZrₓO_{y} coating material, HfₓO_{y} coating material or AlₓO_{y} coating material; B₄C seed material and ZrₓO_{y} coating material, HfₓO_{y} coating material or AlₓO_{y} coating material; Zr or ZrₓO_{y} seed material and AlₓO_{y} coating material; Zr seed material and ZrAlOₓ coating material; AlₓO_{y} seed material and YₓO_{y}, YF_{z}, ZrₓO_{y} or HfₓO_{y} coating materials; Mo seed material and ZrₓO_{y} coating material. An example of YₓO_{y} is Y₂O₃. An example of YF_{z} is YF₃. An example of ZrₓO_{y} is ZrO₂. An example of AlₓO_{y} is Al₂O₃. An example of AlₓO_{y} is Al₂O₃. However, other stoichiometric compositions are also possible.

It is also possible to form an only partial coating on the CNT film, e.g. a coating with a coverage of at most 50%. An average thickness of a partial coating may be 1.0 nm or less, or 0.5 nm or less. Partial coatings may be formed of any of the outer coating materials and/or seed materials listed above. Due to the lower coverage of a partial coating, the optical constants n and k are of lesser relevance to the optical performance of the pellicle membrane. It is hence contemplated that coating and/or seed materials may be selected more freely, with less regard to the optical constants.

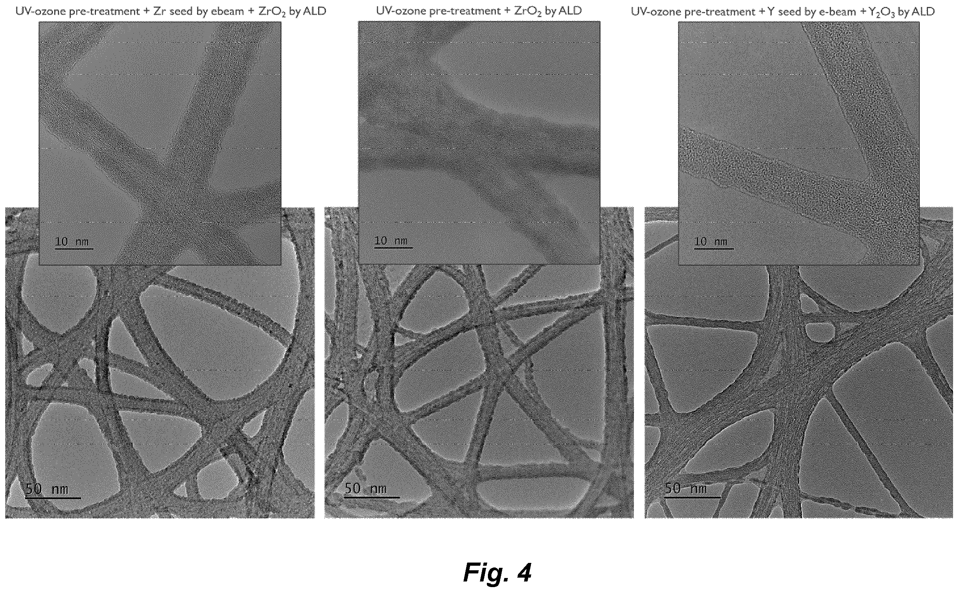

Fig. 4 shows by way of example SEM images of mostly continuous ALD coatings on a film of DWCNTs pre-treated with UV-ozone. The left and pre-coated by e-beam evaporation.

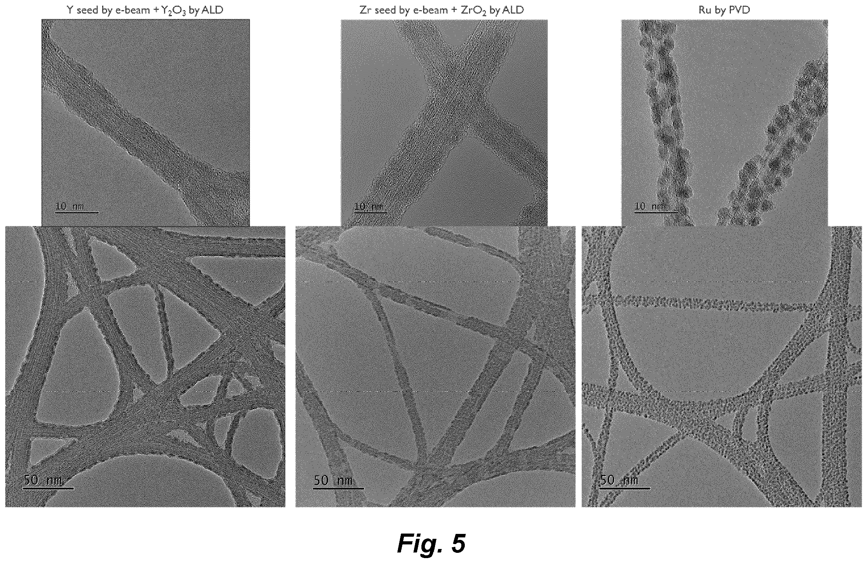

Fig. 5 shows by way of example SEM images of two types of mostly continuous coatings (left and center view) and a partial coating (right view).

Table XII shows optimized structural and coating parameters for a coated pellicle membrane for use in a 0.33NA EUVL scanner with a source power of 300 W and optimized for a maximum level of flare of 0.2%. The CNT film (i.e. the core) is in each case a film of DWCNT bundles with an individual CNT diameter of 2.5 nm. The parameter values are derived for a coating of Y₂O₃ and are hence applicable to any other coating material (single or composite) with similar optical constants. "EUVT core" and "EUVT coat" indicate the transmission of the uncoated film and the coated film, respectively. As indicated by the final row of the table, a transmission of at least 94% after coating requires an EUVT core of at least 98%.

**Table XII:**

| | **Coating thick. (nm)** | **EUVT core (%) / areal density** (µg/cm²) | **EUVT coat (%)** | **Bundle diam. (nm)** | **CNTs** / **bundle** | **Gap (nm)** |
|---|---|---|---|---|---|---|
| DWCNT T<600 °C | 2.0 | 98.6 / 0.8 | 96.7 | 11.5 | 21 | ~200 |
| DWCNT T<800 °C | 2.0 | 98.4 / 0.9 | 96.7 | 9 | 13 | 120 |
| DWCNT T<800 °C | 1.5 | 97.8 / 1.2 | 95.1 | 9 | 13 | 110 |
| DWCNT T<800 °C | 1.5 | 97.2 / 1.5 | 93.2 | 7 | 8 | 90 |

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. An EUV pellicle comprising:
a pellicle frame; and
a pellicle membrane mounted on the pellicle frame and comprising a film of bundles of carbon nanotubes, CNTs, wherein within any 2 µm × 2 µm region of the film:
an average number of CNTs per bundle is at least 5,
an average bundle diameter is in a range from 6 to 16 nm,
an average areal density is in a range from 0.4 to 6 µg/cm²
an inter-bundle spacing is 250 nm or less, and
a number of walls per CNT is 6 or less.

2. An EUV pellicle according to claim 1, wherein the pellicle membrane is an un-coated pellicle membrane.

3. An EUV pellicle according to claim 2, wherein an average areal density is in a range from 1 to 6 µg/cm².

4. An EUV pellicle according to claim 2, wherein an average areal density is in a range from 0.5 to 3 µg/cm².

5. An EUV pellicle according to claim 1, wherein:
the pellicle membrane is a coated pellicle membrane,
an average bundle diameter is in a range from 6 to 14 nm, and
a number of walls per CNT is 4 or less.

6. An EUV pellicle according to claim 5, wherein a coating of the pellicle membrane comprises a coating material selected from the group of Al, B, C, Hf, La, Mo, Nb, Ru, Si, Ti, Y, or Zr; or carbides, nitrides or oxides thereof.

7. An EUV pellicle according to any one of claims 5-6, wherein an average areal density is in a range from 0.4 to 4.0 µg/cm²

8. An EUV pellicle according to claim 7, wherein an average thickness of the coating is 2.0 nm or less and a degree of coverage of the coating on the film is at least 80 %.

9. An EUV pellicle according to claim 7, wherein an average thickness of the coating is 1.0 nm or less and a degree of coverage of the coating on the film is at most 50 %.

10. An EUV pellicle according to any one of claims 5-6, wherein an average areal density is in a range from 0.4 to 2.0 µg/cm².

11. An EUV pellicle according to claim 10, wherein an average thickness of the coating is 1.0 nm or less and a degree of coverage of the coating on the film is at least 80 %.

12. An EUV pellicle according to claim 10, wherein an average thickness of the coating is 1.0 nm or less and a degree of coverage of the coating on the film is at most 50 %.

13. An EUV pellicle according to any one of the preceding claims, wherein the film comprises bundles of: single-walled CNTs, double-walled CNTs, multi-walled CNTs; and/or bundles of combinations of two or more of: single-walled CNTs, double-walled CNTs, multi-walled CNTs.

14. An EUV pellicle according to any one of the preceding claims, wherein the film comprises multi-walled CNTs and single-walled and/or double-walled CNTs, and wherein a percentage by mass of multi-walled CNTs of the film is smaller than a concentration by mass of single- or double-walled CNTs of the film.

15. An EUV pellicle according to any one of the preceding claims, wherein the film comprises a first layer of bundles of single- and/or double-walled CNTs, and a second layer of multi-walled CNTs, wherein the first layer forms a network of overlapping CNTs and the other layer forms a layer of aligned CNTs arranged on the first layer, or vice versa.

## Patentansprüche

1. EUV-Pellikel, umfassend:
einen Pellikelrahmen; und
eine Pellikelmembran, die an dem Pellikelrahmen montiert ist und eine Folie aus Bündeln von Kohlenstoffnanoröhrchen, CNTs, umfasst, wobei innerhalb einer beliebigen Region von 2 µm × 2 µm der Folie:
eine durchschnittliche Anzahl von CNTs pro Bündel mindestens 5 beträgt,
ein durchschnittlicher Bündeldurchmesser in einem Bereich von 6 bis 16 nm liegt,
eine durchschnittliche Flächendichte in einem Bereich von 0,4 bis 6 µg/cm² liegt,
ein Zwischenbündelabstand 250 nm oder weniger beträgt, und
eine Anzahl von Wänden pro CNT 6 oder weniger beträgt.

2. EUV-Pellikel nach Anspruch 1, wobei die Pellikelmembran eine unbeschichtete Pellikelmembran ist.

3. EUV-Pellikel nach Anspruch 2, wobei eine durchschnittliche Flächendichte in einem Bereich von 1 bis 6 µg/cm² liegt.

4. EUV-Pellikel nach Anspruch 2, wobei eine durchschnittliche Flächendichte in einem Bereich von 0,5 bis 3 µg/cm² liegt.

5. EUV-Pellikel nach Anspruch 1, wobei:
die Pellikelmembran eine beschichtete Pellikelmembran ist,
ein durchschnittlicher Bündeldurchmesser in einem Bereich von 6 bis 14 nm liegt, und
eine Anzahl von Wänden pro CNT 4 oder weniger beträgt.

6. EUV-Pellikel nach Anspruch 5, wobei eine Beschichtung der Pellikelmembran ein Beschichtungsmaterial umfasst, das aus der Gruppe von Al, B, C, Hf, La, Mo, Nb, Ru, Si, Ti, Y oder Zr; oder aus den Karbiden, Nitriden oder Oxiden derselben ausgewählt wird.

7. EUV-Pellikel nach einem der Ansprüche 5 bis 6, wobei eine durchschnittliche Flächendichte in einem Bereich von 0,4 bis 4,0 µg/cm² liegt.

8. EUV-Pellikel nach Anspruch 7, wobei eine durchschnittliche Dicke der Beschichtung 2,0 nm oder weniger beträgt, und ein Abdeckungsgrad der Beschichtung auf der Folie mindestens 80 % beträgt.

9. EUV-Pellikel nach Anspruch 7, wobei eine durchschnittliche Dicke der Beschichtung 1,0 nm oder weniger beträgt, und ein Abdeckungsgrad der Beschichtung auf der Folie höchstens 50 % beträgt.

10. EUV-Pellikel nach einem der Ansprüche 5 bis 6, wobei eine durchschnittliche Flächendichte in einem Bereich von 0,4 bis 2,0 µg/cm² liegt.

11. EUV-Pellikel nach Anspruch 10, wobei eine durchschnittliche Dicke der Beschichtung 1,0 nm oder weniger beträgt, und ein Abdeckungsgrad der Beschichtung auf der Folie mindestens 80 % beträgt.

12. EUV-Pellikel nach Anspruch 10, wobei eine durchschnittliche Dicke der Beschichtung 1,0 nm oder weniger beträgt, und ein Abdeckungsgrad der Beschichtung auf der Folie höchstens 50 % beträgt

13. EUV-Pellikel nach einem der vorhergehenden Ansprüche, wobei die Folie Bündel von: einzelwandigen CNTs, doppelwandigen CNTs, mehrwandigen CNTs; und/oder Bündel von Kombinationen aus zwei oder mehreren von: einzelwandigen CNTs, doppelwandigen CNTs, mehrwandigen CNTs umfasst.

14. EUV-Pellikel nach einem der vorhergehenden Ansprüche, wobei die Folie mehrwandige CNTs und einzelwandige und/oder doppelwandige CNTs umfasst, und wobei ein Massenanteil von mehrwandigen CNTs der Folie geringer als eine Massenkonzentration von einzel- oder doppelwandigen CNTs der Folie ist.

15. EUV-Pellikel nach einem der vorhergehenden Ansprüche, wobei die Folie eine erste Schicht von Bündeln von einzel- und/oder doppelwandigen CNTs und eine zweite Schicht von mehrwandigen CNTs umfasst, wobei die erste Schicht ein Netz von überlappenden CNTs bildet, und die andere Schicht eine Schicht von ausgerichteten CNTs bildet, die auf der ersten Schicht angeordnet sind, oder umgekehrt.

## Revendications

1. Pellicule EUV comprenant :
un cadre de pellicule ; et
une membrane pelliculaire montée sur le cadre de pellicule et comprenant un film de faisceaux de nanotubes de carbone, NTC, dans lequel dans n'importe quelle région de 2 µm × 2 µm du film,
un nombre moyen de NTC par faisceau est d'au moins 5,
un diamètre moyen de faisceau est dans une plage de 6 à 16 nm et
une densité surfacique moyenne est dans une plage de 0,4 à 6 µg/cm²
un espacement inter-faisceau est de 250 nm ou moins et
un nombre de parois par CNT est de 6 ou moins.

2. Pellicule EUV selon la revendication 1, dans laquelle la membrane pelliculaire est une membrane pelliculaire non revêtue.

3. Pellicule EUV selon la revendication 2, dans laquelle une densité surfacique moyenne est comprise dans une plage de 1 à 6 µg/cm².

4. Pellicule EUV selon la revendication 2, dans laquelle une densité surfacique moyenne est comprise dans une plage de 0,5 à 3 µg/cm ².

5. Pellicule EUV selon la revendication 1, dans laquelle :
la membrane pelliculaire est une membrane pelliculaire revêtue,
un diamètre moyen de faisceau est compris entre 6 et 14 nm et
le nombre de parois par NTC est de 4 ou moins.

6. Pellicule EUV selon la revendication 5, dans laquelle un revêtement de la membrane pelliculaire comprend un matériau de revêtement choisi dans le groupe Al, B, C, Hf, La, Mo, Nb, Ru, Si, Ti, Y ou Zr; ou leurs carbures, nitrures ou oxydes.

7. Pellicule EUV selon une quelconque des revendications 5 à 6, dans laquelle une densité surfacique moyenne est comprise dans une plage de 0,4 à 4,0 µg/cm².

8. Pellicule EUV selon la revendication 7, dans laquelle une épaisseur moyenne du revêtement est de 2,0 nm ou moins et un degré de couverture du revêtement sur le film est d'au moins 80%.

9. Pellicule EUV selon la revendication 7, dans laquelle une épaisseur moyenne du revêtement est de 1,0 nm ou moins et un degré de couverture du revêtement sur le film est d'au plus 50%.

10. Pellicule EUV selon une quelconque des revendications 5 et 6, dans laquelle une densité surfacique moyenne est comprise dans la plage de 0,4 à 2,0 µg/cm².

11. Pellicule EUV selon la revendication 10, dans laquelle une épaisseur moyenne du revêtement est de 1,0 nm ou moins et un degré de couverture du revêtement sur le film est d'au moins 80%.

12. Pellicule EUV selon la revendication 10, dans laquelle une épaisseur moyenne du revêtement est de 1,0 nm ou moins et un degré de couverture du revêtement sur le film est d'au plus 50%.

13. Pellicule EUV selon une quelconque des revendications précédentes, dans laquelle le film comprend des faisceaux de : NTC à simple paroi, NTC à double paroi, NTC à parois multiples ; et/ou des faisceaux de combinaisons de deux ou plusieurs des éléments suivants : à simple paroi NTC, NTC à double paroi, NTC à parois multiples.

14. Pellicule EUV selon une quelconque des revendications précédentes, dans laquelle le film comprend des NTC à parois multiples et des NTC à simple et/ou double paroi, et dans laquelle un pourcentage en masse de NTC à parois multiples du film est inférieur à une concentration en masse de NTC à simple ou double paroi du film

15. Pellicule EUV selon une quelconque des revendications précédentes, dans laquelle le film comprend une première couche de faisceaux de NTC à simple et/ou double paroi et une deuxième couche de NTC à parois multiples, dans laquelle la première couche forme un réseau de NTC superposés et l'autre couche forme une couche de NTC alignés disposés sur la première couche ou vice versa.
